# FASCICULE DE BREVET EUROPEEN

(11) **EP 0 379 817 B1**
(45) Date de publication et mention de la délivrance du brevet: **09.03.1994**
(21) Numéro de dépôt: 89403572.4
(22) Date de dépôt: 20.12.1989
(51) Int. Cl.: H03F 1/30

(54) **Circuit intégré à décalage compensé et procédé pour sa mise en oeuvre**
Integrierte Schaltung mit Nullpunktabgleich und Verfahren zu seiner Ausführung
Integrated circuit with offset correction, and process for using same

(30) Priorité: 23.12.1988 FR 8817108
(43) Date de publication de la demande: 01.08.1990
(73) Titulaire: PHILIPS COMPOSANTS, 92150 Suresnes (FR); Philips Electronics N.V., 5621 BA Eindhoven (NL)
(72) Inventeur: Dumont, Daniel, Societé Civile S.P.I.D., F-75007 Paris (FR)
(74) Mandataire: Charpail, François

(56) Documents cités:
- EP-A- 0 118 178
- FR-A- 2 173 032
- US-A- 3 735 273
- US-A- 4 356 450

## Description

La présente invention a pour objet un circuit intégré à décalage compensé.

La compensation des décalages des circuits intégrés ("offset") est en général le résultat d'améliorations des schémas électriques et/ou de la technologie de fabrication. Pour obtenir des tensions de décalage très faibles et compte tenu de la dispersion sur la fabrication, on est obligé d'avoir recours à des tris, ce qui diminue le rendement réel en fabrication. On connaît des dispositifs de compensation de décalage (par ex. US 4810973), mais ceux-ci ne se prêtent pas à une intégration.

La présente invention propose un circuit intégré dont la structure permet une compensation des décalages réalisée de préférence lors du contrôle sous pointes du circuit.

L'idée de base de l'invention consiste à mémoriser dans le circuit lui-même au moins une valeur de correction d'erreur mesurée lors du test du circuit et destinée à compenser le décalage correspondant, tout en limitant la surface utilisée sur le semi-conducteur.

Le circuit selon l'invention est ainsi caractérisé en ce qu'il comporte au moins un circuit de compensation de décalage d'un élément de circuit présentant un compteur dont la sortie est connectée à une entrée d'une mémoire programmable et à une première entrée d'un convertisseur numérique-analogique, en ce qu'une sortie de la mémoire programmable est connectée à une deuxième entrée du convertisseur numérique-analogique en parallèle avec la première entrée, en ce qu'une entrée du compteur est susceptible d'être attaquée par un signal impulsionnel de comptage, en ce qu'une entrée d'écriture de la mémoire programmable est susceptible d'être attaquée par un signal d'écriture, et en ce que la sortie du convertisseur numérique-analogique est agencée pour produire un signal de sortie susceptible de compenser ledit décalage.

Le décalage peut être une tension de décalage et la sortie dudit convertisseur connectée à l'entrée d'une source de courant commandable, en série avec une résistance dont une première borne est connectée à une source de tension de référence (U_{ref}) et dont une deuxième borne est connectée à un point de compensation dudit élément de circuit.

Selon un mode de réalisation avantageux, le circuit est caractérisé en ce que l'entrée du compteur et/ou l'entrée d'écriture de la mémoire programmable sont reliée(s) au pôle de mode commun à travers une résistance. Ceci permet de verrouiller lesdites entrées au niveau bas lors d'une utilisation ultérieure du circuit, et donc d'éliminer un risque éventuel de déprogrammation.

Selon un mode de réalisation préféré, lorsque le compteur est à l'état 0, le dispositif de compensation est agencé pour que l'élément de circuit soit en état de surcompensation du décalage, compte tenu des dispersions de fabrication, et en ce que le convertisseur numérique-analogique est agencé pour que son signal de sortie produise une compensation décroissant au fur et à mesure du chargement de compteur.

L'invention concerne également un procédé pour la mise en oeuvre du circuit précité caractérisé en ce qu'il comporte les étapes suivantes :
a) mesure d'au moins un décalage à compenser
b) incrémentation du compteur par un signal impulsionnel de comptage.
c) itération des étapes a) et b) jusqu'à compensation du décalage.
d) inscription dans la mémoire du compte du compteur obtenu lors de la dernière étape b) de l'itération.

L'invention sera mieux comprise à la lecture de la description qui va suivre, donnée à titre d'exemple non limitatif, en liaison avec les dessins qui représentent :
- la figure 1, un mode de réalisation de l'invention concernant la compensation du décalage de tension d'entrée d'un amplificateur intégré.
- la figure 2, une variante avantageuse de la figure 1.

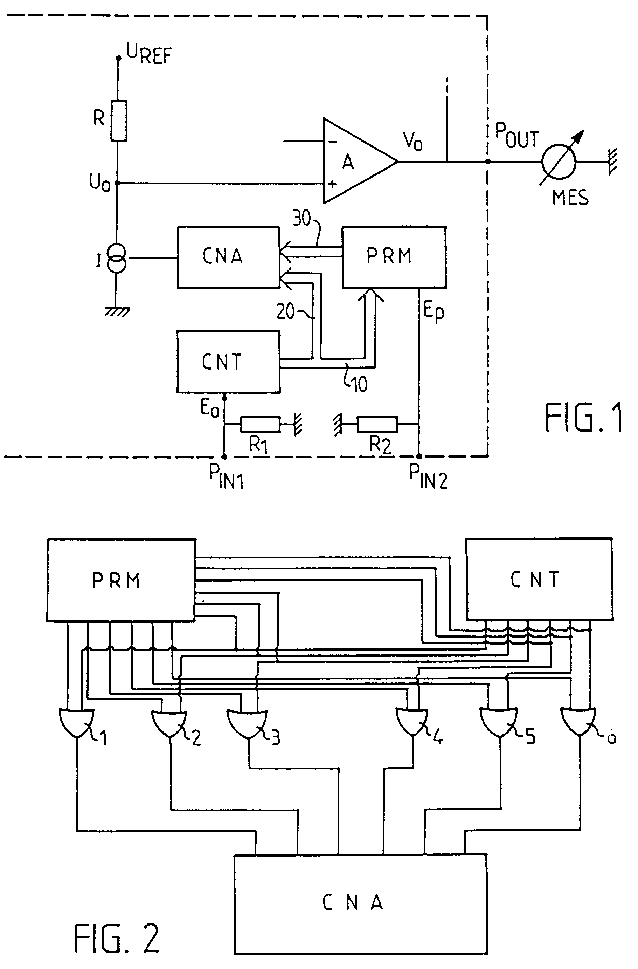

Selon la figure 1, un amplificateur différentiel A intégré présente en sortie une tension continue de décalage Vₒ dont la valeur est susceptible de varier d'un exemplaire à l'autre du même circuit en raison des dispersions inévitables du procédé de fabrication. Cet amplificateur A peut être par exemple un des étages d'entrée d'un circuit intégré présentant par ailleurs d'autres fonctions. On comprendra en particulier que l'invention peut être mise en oeuvre pour compenser les tensions de décalage de plusieurs éléments de circuit, par exemple de plusieurs étages d'entrée en mettant en oeuvre autant de dispositifs de compensation que de tensions de décalage à compenser. Le circuit de la figure 1 se limite, dans un but d'illustration, au cas d'une seule tension.

Un compteur CNT présente une entrée de comptage E_{c} accessible à des impulsions de comptage par une broche du circuit P_{IN1}. Une mémoire programmable PRM présente une entrée de programmation Eₚ accessible à un signal impulsionnel de programmation par une broche du circuit P_{IN2}. La sortie du compteur CNT attaque une entrée de la mémoire programmable PRM (bus 10) et une entrée d'un convertisseur numérique-analogique CNA (bus 20). La sortie de la mémoire programmable PRM attaque (bus 30) l'entrée du convertisseur numérique-analogique CNA en parallèle avec la sortie du compteur CNT (bus 20). Soit la valeur inscrite dans le compteur CNT, soit celle inscrite dans la mémoire PRM est prise en compte par le convertisseur CNA. La sortie du convertisseur numérique-analogique délivre une tension qui commande le courant d'une source de courant I commandée en tension et qui est disposée en série avec une résistance R connectée à une source de tension de référence U_{REF}. Le point commun à la résistance R et à la source de courant I est connectée à une entrée de l'amplificateur A. La variation de courant I traversant la résistance R fait varier la tension Uₒ appliquée à ladite entrée de l'amplificateur A et donc la valeur de la tension de décalage Vₒ mesurée en sortie sur une borne P_{OUT} du circuit à l'aide d'un dispositif de mesure de tension MES.

Les bornes d'entrées P_{IN1} et P_{IN2} sont avantageusement reliées au pôle de mode commun (masse) à travers des résistances R₁ et R₂ ce qui permet de les ramener au niveau bas en l'absence de signal à leur entrée.

Lors du test de contrôle sous pointes du circuit, la tension V est mesurée par le dispositif MES. Si cette valeur est supérieure au seuil que l'on s'est fixé, une impulsion de comptage appliquée à la borne P_{IN1}, laquelle incrémente d'une unité le compteur CNT, ce qui modifie la tension à la sortie du convertisseur CNA et donc le courant I, ce qui modifie Vₒ. Ce cycle est réitéré jusqu'à ce que Vₒ soit inférieur à un seuil donné ou bien passe par 0. Une impulsion appliquée sur la broche P_{IN2} qui attaque l'entrée Eₚ de programmation de la mémoire PRM fixe alors dans celle-ci la dernière valeur qui y a été appliquée par la sortie du compteur CNT. Selon un mode préféré, on choisit les paramètres du dispositif de manière telle que la valeur de I surcompense à coup sûr, compte tenu des dispersions de fabrication, la tension de décalage que l'on peut obtenir en sortie, lorsque le compteur CNT est à zéro. En d'autres termes, lorsque CNT est à zéro, Vₒ est supérieur en valeur absolue à Vₒₘₐₓ, tension maximale de décalage.

Dans le cas représenté à la figure 1, plus le compteur CNT a un compte élevé, plus la tension appliquée à l'entrée de commande de la source de courant I (par exemple la base d'un transistor formant source de courant) est élevée et plus le courant I est élevé, et donc plus U_{REF}-Uₒ augmente. Si Uₒ est appliqué à l'entrée non inverseuse de A, Vₒ diminue également. On voit donc que le choix de U_{REF}, de R et des paramètres de la source I permet de réaliser une large variation de la tension de décalage Vₒ mesurée, et donc une bonne compensation.

La figure 2 représente une variation de réalisation de la figure 1 selon laquelle les bus 20 et 30 sont raccordés bit par bit à des portes OU 1 à 6 (pour une réalisation à 6 bits) de manière à attaquer en parallèle le convertisseur CNA. Lors de l'opération de mesure, le bus 20 impose la valeur présente dans le compteur CNT. Lors de l'utilisation du circuit, le bus 30 impose la valeur programmée dans la mémoire PRM, la sortie du compteur restant à zéro.

## Revendications

1. Circuit intégré à décalage compensé caractérisé en ce qu'il comporte au moins un circuit de compensation de décalage d'un élément de circuit, présentant un compteur (CNT) dont la sortie est connectée à une entrée d'une mémoire programmable (PRM) et à une première entrée d'un convertisseur numérique-analogique (CNA), en ce qu'une sortie de la mémoire programmable (PRM) est connectée à une deuxième entrée du convertisseur numérique-analogique (CNA), en parallèle avec la première entrée, en ce qu'une entrée de compteur (CNT) est susceptible d'être attaquée par un signal impulsionnel de comptage, en ce qu'une entrée d'écriture de la mémoire programmable est susceptible d'être attaquée par un signal d'écriture, et en ce que la sortie du convertisseur numérique-analogique est agencée pour produire un signal de sortie susceptible de compenser ledit décalage.

2. Circuit intégré selon la revendication 1 caractérisé en ce que ledit décalage consiste en une tension de décalage et en ce que la sortie du convertisseur numérique-analogique (CNA) est connectée à l'entrée d'une source de courant commandable, en série avec une résistance dont une première borne est connectée à une source de tension de référence (U_{REF}) et dont une deuxième borne est connectée à un point de compensation dudit élément de circuit.

3. Circuit selon une des revendications 1 ou 2 caractérisé en ce que l'entrée du compteur (CNT) est reliée au pôle de mode commun à travers une première résistance (R₁).

4. Circuit selon une des revendications précédentes caractérisé en ce que l'entrée d'écriture de la mémoire programmable (PRM) est reliée au pôle de mode commun à travers une deuxième résistance (R₂).

5. Circuit selon une des revendications précédentes, caractérisé en ce que, lorsque le compteur est à l'état 0, le dispositif de compensation est agencé pour que l'élément de circuit soit en état de surcompensation, et en ce que le convertisseur numérique-analogique (CNA) est agencé pour que son signal de sortie produise une compensation décroissant au fur et à mesure du chargement du compteur.

6. Procédé pour la mise en oeuvre d'un circuit selon l'une des revendications précédentes caractérisé en ce qu'il comporte les étapes suivantes :
a) mesure d'au moins un décalage à compenser
b) incrémentation du compteur par un signal impulsionnel de comptage.
c) itération des étapes a) et b) jusqu'à compensation dudit décalage.
d) inscription dans la mémoire programmable (PRM) du compte du compteur atteint lors de la dernière étape b) de l'itération.

## Claims

1. An integrated circuit with offset compensation, characterized in that it comprises at least one circuit for compensation of the offset of one circuit element, which compensation circuit comprises a counter (CNT) whose output is connected to an input of a programmable memory (PRM) and to a first input of a digital-to-analog converter (CNA), an output of the programmable memory (PRM) is connected to a second input of the digital-to-analog converter (CNA), in parallel with the first input, an input of the counter (CNT) is arranged to receive a counting pulse signal, a write input of the programmable memory is arranged receive a write signal, and the output of the digital-to-analog converter is adapted to supply an output signal capable of compensating for said offset.

2. An integrated circuit as claimed in Claim 1, characterized in that said offset is an offset voltage and the output of the digital-to-analog converter (CNA) is connected to the input of a controllable current source, in series with a resistor having a first terminal connected to a reference voltage source (U_{REF}) and having a second terminal connected to a compensation point of said circuit element.

3. A circuit as claimed in Claim 1 or 2, characterized in that the input of the counter (CNT) is connected to the common-mode terminal *via* a first resistor (R₁).

4. A circuit as claimed in any one of the preceding Claims, characterized in that the write input of the programmable memory (PRM) is connected to the common-mode terminal *via* a second resistor (R₂).

5. A circuit as claimed in any one of the preceding Claims, characterized in that, when the counter is in the 0-state, the compensation device is adapted to provide overcompensation for the circuit element, and the analog-to-digital converter (CNA) is adapted in such a way that its output signal provides a compensation which decreases as the counter is incremented.

6. A method for the use of a circuit as claimed in any one of the preceding Claims, characterized in that it comprises the following steps:
a) measurement of at least one offset to be compensated,
b) incrementation of the counter by a counting pulse signal,
c) iteration of steps a) and b) until compensation for said offset is obtained,
d) loading of the count reached by the counter in the last step b) of the iteration into the programmable memory (PRM).

## Patentansprüche

1. Integrierte Schaltung mit Offsetkompensation, dadurch gekennzeichnet, daß sie mindestens eine Schaltung zur Kompensation des Offset eines Schaltungselements umfaßt, wobei diese Schaltung einen Zähler (CNT) aufweist, dessen Ausgang mit einem Eingang eines programmierbaren Speichers (PRM) und einem ersten Eingang eines Digital-Analog-Umsetzers (CNA) verbunden ist, daß ein Ausgang des programmierbaren Speichers (PRM) mit einem zweiten Eingang des Digital-Analog-Umsetzers (CNA), parallel zu dem ersten Eingang, verbunden ist, daß ein Eingang des Zählers (CNT) für das Aufnehmen eines Zählimpulssignals eingerichtet ist, daß ein Schreibeingang des programmierbaren Speichers zum Aufnehmen eines Schreibsignals eingerichtet ist und daß der Ausgang des Digital-Analog-Umsetzers zum Erzeugen eines zur Kompensation des genannten Offset geeigneten Ausgangssignals ausgelegt ist.

2. Integrierte Schaltung nach Anspruch 1, dadurch gekennzeichnet, daß der Offset aus einer Offsetspannung besteht und daß der Ausgang des Digital-Analog-Umsetzers (CNA) mit dem Eingang einer steuerbaren Stromquelle verbunden ist, in Reihe mit einem Widerstand, dessen erster Anschluß mit einer Bezugsspannungsquelle (U_{ref}) und dessen zweiter Anschluß mit einem Kompensationspunkt des genannten Schaltungselements verbunden ist.

3. Schaltung nach Anspruch 1 oder 2, dadurch gekennzeichnet, daß der Eingang des Zählers (CNT) über einen ersten Widerstand (R₁) mit dem Pol gleicher Phase verbunden ist.

4. Schaltung nach einem der vorhergehenden Ansprüche, dadurch gekennzeichnet, daß der Schreibeingang des programmierbaren Speichers (PRM) über einen zweiten Widerstand (R₂) mit dem Pol gleicher Phase verbunden ist.

5. Schaltung nach einem der vorhergehenden Ansprüche, dadurch gekennzeichnet, daß, wenn der Zähler im Nullzustand ist, die Kompensationsanordnung so ausgelegt ist, daß das Schaltungselement überkompensiert ist, und daß der Digital-Analog-Umsetzer (CNA) so ausgelegt ist, daß sein Ausgangssignal eine mit zunehmendem Zählerstand abnehmende Kompensation bewirkt.

6. Verfahren zur Verwendung einer Schaltung nach einem der vorhergehenden Ansprüche, dadurch gekennzeichnet, daß es die folgenden Schritte umfaßt:
a) Messung mindestens eines zu kompensierenden Offset
b) Inkrementierung des Zählers durch ein Zählimpulssignal
c) Iteration der Schritte a) und b) bis zur Kompensation des genannten Offset
d) Beschreiben des programmierbaren Speichers (PRM) mit dem bei dem letzten Schritt b) der Iteration erreichten Zählerstand.
